(19) Europäisches Patentamt / European Patent Office / Office européen des brevets

(11) **EP 3 507 899 B1**

(12) **FASCICULE DE BREVET EUROPEEN**

(45) Date de publication et mention
de la délivrance du brevet:
**12.08.2020 Bulletin 2020/33**

(21) Numéro de dépôt: **17757747.5**

(22) Date de dépôt: **23.08.2017**

(51) Int Cl.:
***H02P 27/08*** *(2006.01)*

(86) Numéro de dépôt international:
**PCT/EP2017/071189**

(87) Numéro de publication internationale:
**WO 2018/041685 (08.03.2018 Gazette 2018/10)**

(54) **ENSEMBLE MÉCATRONIQUE PILOTÉ PAR UN SIGNAL EN MODULATION DE LARGEUR D'IMPULSION**

MITTELS EINES PULSWEITENMODULATIONSSIGNALS GESTEUERTE MECHATRONISCHE ANORDNUNG

MECHATRONIC ASSEMBLY CONTROLLED BY A PULSE-WIDTH MODULATION SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.09.2016 FR 1658199**

(43) Date de publication de la demande:
**10.07.2019 Bulletin 2019/28**

(73) Titulaire: **MMT AG**
**6300 Zug (CH)**

(72) Inventeur: **CALLERANT, Guillaume**
**68210 Chavannes-sur-l'Etang (FR)**

(74) Mandataire: **IP Trust**
**2, rue de Clichy**
**75009 Paris (FR)**

(56) Documents cités:
**WO-A1-95/08214       WO-A1-2016/079315**
**WO-A2-2014/091152     GB-A- 2 013 011**

**Description**

**Domaine de l'invention**

La présente invention concerne le domaine des ensembles mécatroniques commandés en modulation de largeur d'impulsion, préférentiellement utilisés, mais non limitativement, pour des applications automobiles telles que par exemple le déphasage de l'arbre à cames.

**Etat de la technique**

On connaît dans l'état de la technique la demande de brevet française FR14/61241 décrivant un ensemble mécatronique pour l'entrainement d'un organe destiné à être relié d'une part à une source électrique continue de puissance et d'autre part à une unité de commande ECU comprenant un calculateur pour l'exécution d'un algorithme d'asservissement délivrant une information de direction et de couple, ledit ensemble comprenant un actionneur formé par un moteur électrique sans balai polyphasé à P phases (où P > 1), des sondes de détection binaires de la position du rotor dudit moteur, un circuit électronique comprenant un pont de puissance pour l'alimentation des P phases du moteur. Cet ensemble de l'art antérieur comporte en outre un circuit électronique de pilotage embarqué exempt de microcontrôleur, calculateur et de mémoire dont l'entrée reçoit ladite information de direction et de couple du contrôleur et dont la sortie commande ledit pont de puissance assurant l'auto-commutation du moteur en combinant les informations en provenance du signal de direction et de couple, des sondes de détection binaires de la position du rotor et d'une logique de commutation modulant directement le courant de la source électrique continue de puissance appliquée à chacune desdites phases du moteur et en ce que l'information de couple et de direction fournie par le contrôleur est distincte du signal de puissance délivré seulement par la source de puissance.

On connaît aussi dans l'état de la technique la demande de brevet internationale WO2016079315A1 décrivant un ensemble mécatronique pour l'entraînement d'un organe destiné à être relié d'une part à une source électrique continue de puissance et d'autre part à une unité de commande ECU comprenant un calculateur pour l'exécution d'un algorithme d'asservissement délivrant une information de direction et de couple, ledit ensemble comprenant un actionneur formé par un moteur électrique sans balai polyphasé à N phases, des sondes de détection binaires de la position du rotor dudit moteur, un circuit électronique comprenant un pont de puissance pour l'alimentation des N phases du moteur, caractérisé en ce que il comporte en outre un circuit électronique de pilotage embarqué dont l'entrée reçoit ladite information de direction et de couple de l'ECU et dont la sortie commande ledit pont de puissance modulant directement le courant de la source électrique continue de puissance appliquée à chacune desdites phases du moteur et en ce que l'information de couple et de direction fournie par l'ECU est distincte du signal de puissance délivré seulement par la source de puissance. L'information de couple est une information qui permet d'ajuster au final, en sortie du pont de puissance, position ou vitesse du rotor du moteur en charge.

On connaît encore dans l'art antérieur la demande de brevet WO2014091152 décrivant un actionneur mû par un moteur à courant continu DC sans balai tout en conservant les éléments existants identiques au système basé sur un moteur DC à balais. L'actionneur est relié au système de commande par l'intermédiaire d'un connecteur regroupant les signaux analogiques et/ou numériques provenant du capteur de position, ainsi que les signaux combinant la direction et le couple à produire par le moteur BLDC. Un circuit électronique rudimentaire résistant à de forte température (>125°C), gère l'auto-commutation des N phases du moteur à l'aide de N sondes renseignant la position du rotor du moteur. L'objectif de la solution décrite ci-après est de proposer un compromis technologique permettant de répondre aux problématiques citées précédemment proposant une solution économique ne nécessitant pas de microprocesseur, permettant l'emploi d'un moteur à courant continu sans balai en lieu et place d'un moteur à courant continu avec balai, tout en gardant la possibilité d'utiliser un moteur polyphasé réversible et de le piloter dans les deux sens de rotation. L'invention se destine donc à tout moteur polyphasé à N phases.

On connaît également d'autres exemples de tels ensembles mécatroniques décrit dans les demandes de brevet WO95/08214 et GB2013011.

**Inconvénient de l'art antérieur**

Le problème de l'art antérieur est que la vitesse de consigne maximale susceptible d'être envoyée par le circuit de contrôle sans calculateur est limitée par la fréquence de l'information de direction et de couple (ou de vitesse puisqu'une tension donnée d'alimentation va fixer, pour une charge donnée, le couple et la vitesse) transmis par le contrôleur. Cette information de direction et de couple/vitesse est physiquement un signal de contrôle modulé en largeur d'impulsion (MLI) nommé $PWM_{IN}$.

Les contrôleurs (ECU - Electronic Control Unit) intégrés dans les véhicules ont été dimensionnés pour contrôler des vannes électro - hydrauliques nécessitant une fréquence faible du signal de contrôle modulé en largeur d'impulsion, de l'ordre de la centaine à quelques centaines de Hertz (Fréquence PWM$_{IN}$ < 500Hz).

Pour obtenir une vitesse de rotation du moteur BLDC suffisante pour l'application, une solution évidente est d'augmenter la fréquence du signal de contrôle modulé en largeur d'impulsion, ce qui implique une modification matérielle en profondeur du contrôleur.

Par ailleurs, les informations de direction et de vitesse retournées par l'ensemble mécatronique au contrôleur permettant un asservissement de l'application sont transmises via des canaux distincts, pouvant conduire à des erreurs d'interprétation par le contrôleur résultant du défaut de synchronisme entre les deux signaux, ce risque évoluant proportionnellement à la vitesse de rotation du dit moteur BLDC associé et de son module électronique de contrôle du pont de puissance.

Ce second problème est potentiellement lié au problème concernant la limite de vitesse maximale, mais existe aussi indépendamment de cette problématique.

Un troisième problème concerne les valeurs extrêmes du rapport cyclique du signal de contrôle modulé en largeur d'impulsion (proche des valeurs de 0 ou de 100%) qui ne peuvent être générées par les contrôleurs existants.

Un pilotage MLI impose l'utilisation de plages de rapport cyclique proches des valeurs extrêmes pour détecter des défauts électriques sur la ligne de commande MLI. On trouve par exemple les défauts associés à une coupure de la ligne, un court-circuit permanent ou intermittent de ladite ligne à la masse ou à la tension d'alimentation. Ces plages de rapport cyclique ne peuvent donc pas être utilisées pour le codage de l'information de direction et de couple/vitesse.

On perd ainsi une partie de la puissance électrique (typiquement 8%) transmissible au moteur BLDC, cette dernière étant l'image du signal de contrôle MLI.

Ce troisième problème est potentiellement lié au problème concernant la limite de vitesse maximale, mais existe aussi indépendamment de cette problématique.

## Solution apportée par l'invention

L'invention concerne selon son acception la plus générale un ensemble mécatronique pour l'entrainement d'un organe destiné à être relié d'une part à une source électrique continue de puissance et d'autre part à une unité de contrôle électronique comprenant un calculateur pour l'exécution d'un algorithme d'asservissement délivrant un signal d'entrée à modulation de largeur d'impulsion présentant des états discrets et un rapport cyclique codant les informations de direction et de couple/vitesse, ledit ensemble comprenant un moteur électrique sans balai polyphasé à P phases (où P > 1), des sondes de détection binaires de la position du rotor dudit moteur, un pont de puissance pour l'alimentation des P phases du moteur, et un circuit électronique de pilotage embarquédont la sortie commande ledit pont de puissance assurant l'auto-commutation du moteur en combinant les informations en provenance du signal de direction et de couple/vitesse, des sondes de détection binaires de la position du rotor et d'une logique de commutation modulant directement le courant de la source électrique continue de puissance appliquée à chacune desdites phases du moteur, l'information de direction et de couple/vitesse fournie par l'unité de contrôle électronique étant distincte du signal de puissance délivré seulement par la source de puissance, caractérisé en ce qu'il comporte un multiplicateur fréquentiel placé en amont du circuit électronique de pilotage et produisant pour chaque état discret dudit signal d'entrée $X^N$ états discrets d'information haute fréquence de direction et de couple/vitesse présentant le même rapport cyclique que l'état discret d'entrée, d'une durée $X^N$ fois inférieure à la durée de l'état discret du signal d'entrée, où X et N sont des entiers ≥ 1, et dont la fréquence de sortie est supérieure ou égale à la fréquence électrique des phaseurs spatiaux du moteur (8) piloté.

Selon une variante préférée, le circuit électronique de pilotage embarqué (10) est exempt de microcontrôleur, calculateur et de mémoire.

Par exemple, X vaut 2 et N peut éventuellement varier en fonction du régime du moteur.

Préférentiellement, ledit multiplicateur fréquentiel (14) comprend un module de boucle à verrouillage de phase et il peut comprendre un circuit électronique multiplicateur de fréquence composé de N modules élémentaires multiplicateurs de fréquences permettant à chaque étage de multiplier la fréquence de son signal d'entrée et de transmettre le dit signal multiplié 26 au circuit électronique de pilotage embarqué.

Dans un mode alternatif, ledit circuit électronique de pilotage embarqué comprend un circuit électronique de modulation qui génère un signal électrique numérique unidirectionnel modulé présentant des états discrets codés.

Avantageusement, ledit circuit électronique de modulation code ledit signal modulé en fonction de la direction du moteur et/ou en fonction de la vitesse de rotation du moteur.

Dans un mode particulier de réalisation, ledit circuit électronique de modulation module en largeur d'impulsion le signal et code le rapport cyclique de chaque état discret.

Dans un autre mode de réalisation, ledit circuit électronique de modulation module en amplitude le signal et code l'amplitude du niveau haut de chaque état discret avec un rapport cyclique fixe.

Dans un autre mode de réalisation, ledit circuit électronique de modulation module en fréquence le signal et code la fréquence.

Avantageusement ledit circuit électronique de modulation code l'amplitude du niveau haut de chaque état discret en fonction d'une première information, le rapport cyclique en fonction d'une deuxième information et la fréquence en fonction d'une troisième information.

Dans un mode particulier de réalisation ledit circuit électronique de pilotage embarqué comprend un adaptateur d'impédance qui applique une tension à chacun des phaseurs spatiaux selon le rapport cyclique spatial

$$R_{MOSFET} = R_6 \times \frac{100}{R_{6H} - R_{6L}} + \left(100 - \frac{100}{R_{6H} - R_{6L}} \times R_{6H}\right)$$

où R6 désigne le rapport cyclique du signal de commande issu du contrôleur externe, $R_{6H}$ désigne la limite haute du rapport cyclique transmissible par le contrôleur externe, $R_{6L}$ désigne la limite basse du rapport cyclique transmissible par le contrôleur externe.

Dans un autre mode de réalisation particulier ledit circuit électronique de pilotage embarqué comprend un adaptateur d'impédance qui applique une tension à chacun des phaseurs spatiaux selon le rapport cyclique

$$R_{MOSFET} = -\left(R_6 \times \frac{100}{50 - R_{6L}}\right) + \left(100 + \frac{100}{50 - R_{6L}} \times R_{6L}\right)$$

lorsque $R_6$ est inférieur à 50% et

$$R_{MOSFET} = R_6 \times \frac{100}{R_{6H} - 50} + \left(100 - \frac{100}{R_{6H} - 50} \times R_{6H}\right)$$

lorsque $R_6$ est supérieur ou égal à 50% ; ou $R_6$ désigne le rapport cyclique du signal de commande issu du contrôleur externe, $R_{6H}$ désigne la limite haute du rapport cyclique transmissible par le contrôleur externe, $R_{6L}$ désigne la limite basse du rapport cyclique transmissible par le contrôleur externe.

Dans ces derniers modes de réalisation précédents, ladite unité de commande ECU détermine un rapport cyclique $R_6$ inférieur à $R_{6L}$ ou supérieur à $R_{6H}$ pour commander un mode de protection.

## Description détaillée d'un exemple non limitatif de l'invention

La présente invention sera mieux comprise à la lecture de la description détaillée d'un exemple non limitatif de l'invention qui suit, se référant aux dessins annexés où :

- La figure 1 décrit schématiquement un ensemble mécatronique selon l'invention ainsi que les éléments nécessaires à sa commande et son alimentation ;
- la figure 2 représente le schéma de principe d'un exemple d'architecture de multiplicateur fréquentiel ;
- la figure 3 représente le schéma de principe d'une première solution de réalisation du module unitaire de multiplication fréquentielle;
- la figure 4 représente le schéma de principe d'une deuxième solution de réalisation du module de multiplication fréquentielle;
- la figure 5 représente, en exemple, le schéma de principe du circuit générant les signaux de direction et de vitesse;
- les figures 6, 7 et 8 représentent le schéma de principe du circuit précédent selon trois modes d'implémentation différents;
- la figure 9 représente un exemple de modulation des informations de direction et de vitesse retournées par l'ensemble mécatronique au contrôleur permettant un asservissement de l'application;
- la figure 10 représente une variante de réalisation de la modulation des informations de direction et de vitesse retournées par l'ensemble mécatronique au contrôleur permettant un asservissement de l'application;
- la figure 11 représente l'état de l'art de la courbe de vitesse de rotation du moteur BLDC en fonction du rapport cyclique du signal de contrôle MLI;
- la figure 12 représente la courbe de couple du moteur BLDC en fonction du rapport cyclique du signal de contrôle MLI,
- la figure 13 représente une autre alternative à la courbe de couple du moteur BLDC en fonction du rapport cyclique du signal de contrôle MLI.

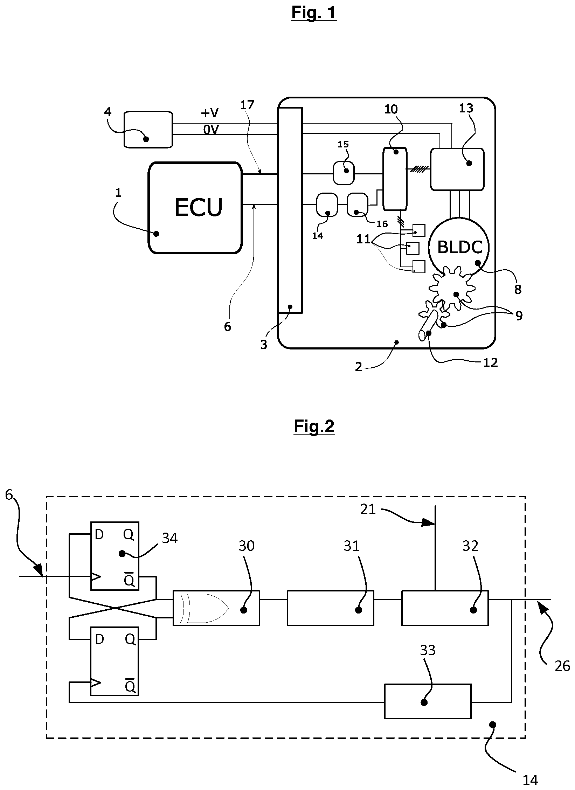

La figure 1 décrit schématiquement un ensemble mécatronique selon l'invention ainsi que les éléments nécessaires à sa commande et alimentation. Il comprend une unité de contrôle électronique -ECU- (1), par exemple un contrôleur automobile, l'ensemble mécatronique (2) selon l'invention, au moins un connecteur (3), une source continue de puissance électrique (4), par exemple une batterie automobile, des sondes de Hall (11) - généralement au nombre de trois lorsque associées à un moteur triphasé - détectant la rotation du moteur sans balai -ou BLDC- (8) et destinées à permettre l'auto-commutation des phases du moteurs, Cette unité de contrôle électronique (1) délivre une information de direction et de couple/vitesse (6) à un circuit électronique de pilotage -ou driver- (10) embarqué. Le signal de puissance venant de la source de puissance (4) est directement appliqué au pont de puissance (13) contenant généralement 6 transistors pour l'alimentation des 3 phases du moteur BLDC (8). Le circuit électronique de pilotage embarqué (10) présente une sortie commandant ledit pont de puissance (13) assurant l'auto-commutation du moteur (8) en combinant les informations en provenance du signal de direction et de couple/vitesse (6), des sondes (11) de détection binaires de la position du rotor et d'une logique de commutation (non montrée) modulant directement le courant de la source électrique continue de puissance (4) appliquée à chacune desdites phases du moteur (8), l'information de direction et de couple/vitesse (6) fournie par l'unité de contrôle électronique (1).

L'ensemble mécatronique est destiné à déplacer un organe extérieur via un arbre de sortie (12) avec ou sans la présence d'un ensemble de réduction mécanique du mouvement (9). A titre d'exemple non limitatif, le dispositif permet de commander le déplacement d'un déphaseur d'arbre à cames.

L'ensemble mécatronique (2) peut intégrer un multiplicateur de fréquence (14) produisant pour chaque état discret du signal d'entrée $X^N$ états discrets de sortie présentant le même rapport cyclique que l'état discret d'entrée, d'une durée $X^N$ fois inférieure à la durée de l'état discret du signal d'entrée, où X est un entier et où N est un entier $\geq 1$, et dont la fréquence de sortie est supérieure ou égale à la fréquence électrique des phaseurs spatiaux du moteur piloté. Ce multiplicateur fréquentiel (14) permet de répondre à deux problèmes de la solution proposée par le brevet FR14/61241 :

A) La fréquence du signal de l'information de direction et de couple/vitesse (6) ($PWM_{IN}$) doit être supérieure à la fréquence électrique du moteur à sa vitesse à vide multipliée par un facteur 6 dans le cadre d'un moteur triphasé. Ceci afin de garantir que l'énergie sera constante dans tous les phaseurs spatiaux moteur.

B) Les contrôleurs (ECU - Electronic Control Unit) intégrés dans les véhicules ont été dimensionnés pour contrôler des vannes électrohydrauliques, or ce type de solution nécessite une fréquence de contrôle faible (100Hz < $FPWM_{IN}$ < 1000Hz). Aujourd'hui l'électrification de certaines applications (déphaseur d'arbre à cames, soit « eVCP ») avec les technologies à entraînement direct ou à installation simplifiée (par exemple la solution proposée par le brevet FR14/61241) nécessitent des fréquences de contrôles plus élevées ($FPWM_{IN}$ > 15'000Hz).

L'ensemble mécatronique (2) peut intégrer également un circuit électronique de modulation (15) modulant sur un seul support physique sous la forme d'un signal électrique numérique unidirectionnel (17) les informations instantanées de direction (du sens de rotation) et de vitesse rotorique du moteur BLDC retournées par l'ensemble mécatronique (2) à l'unité de contrôle électronique (1). Le circuit électronique de modulation (15) utilise l'information de vitesse issue des états des capteurs à effet Hall digitaux (11) ainsi que l'information de position déduit de la séquence des signaux de contrôle produits par le circuit de pilotage (10) permettant de générer les phaseurs spatiaux via le pont de puissance (13). Ce circuit électronique de modulation (15) permet de répondre à un problème de la solution proposée par le brevet FR14/61241 :

C) Les informations de direction et de vitesse retournées par l'ensemble mécatronique au contrôleur permettant un asservissement de l'application sont transmises via des canaux distincts, pouvant conduire à des erreurs d'interprétation par l'unité de contrôle électronique (1) résultant du défaut de synchronisme entre les deux signaux.

L'ensemble mécatronique (2) peut intégrer également un adaptateur d'impédance (16) permettant d'optimiser l'énergie transmise par le pont de puissance (13) au moteur BLDC (8) au travers de chacun des 6 phaseurs électriques (phaseurs spatiaux) jusqu'à contrôler le pont en pas entier, ce qui revient à appliquer un rapport cyclique au niveau du pont de puissance de 100%. L'adaptateur d'impédance (16) permet également de modifier la loi de contrôle entre le rapport cyclique du signal d'information de direction et de couple/vitesse (6) et le rapport cyclique des signaux de contrôle des transistors du pont de puissance dans le cas d'un contrôle en tension. Cet adaptateur d'impédance (16) permet de répondre à un problème de la solution proposée par le brevet FR14/61241 :

D) Une partie de la puissance électrique disponible au niveau de la source de puissance (4) n'est pas transmissible au moteur BLDC (8) par le pont de puissance (13).

## Description détaillée du multiplicateur fréquentiel (14)

Figure 1, la solution proposée consiste en l'intégration d'un multiplicateur fréquentiel (14) permettant d'utiliser un signal d'information de direction et de couple/vitesse (6) dans les basses fréquences couplé à toute solution de pilotage moteur réalisé par des blocs matériels sans calculateur, logiciel ou mémoire. L'unité de contrôle électronique (1) délivre une information de direction et de couple/vitesse (6) à un circuit électronique multiplicateur de fréquence (14) conservant l'information de direction et de couple/vitesse qu'il transmet au circuit électronique de pilotage (10) embarqué à une fréquence plus élevée que celle du signal (6). Le signal de puissance venant de la source de puissance (4) est directement appliqué au pont de puissance (13) contenant généralement 6 transistors pour l'alimentation des 3 phases du moteur BLDC (8).

Figure 2 est représentée une première solution de réalisation du multiplicateur fréquentiel (14), utilisant la boucle à verrouillage de phase (PLL en anglais) qui lorsqu'elle est verrouillée, génère un signal d'information haute fréquence de direction et de couple/vitesse (26) égal au signal d'information de direction et de couple/vitesse (6) multiplié par un facteur X et constituée préférentiellement mais de façon non limitative, d'un comparateur de phase (30) (Phase

EP 3 507 899 B1

Frequency Detector - PFD) pouvant être réalisée avec une porte logique OU EXCUSIF (XOR), d'un filtre de boucle (31) avec ou sans module de pompe de charges, d'un oscillateur (32) (Voltage Controlled Oscillator - VCO) contrôlé par une tension de commande (21), d'un diviseur de fréquence (33), d'un système de symétrisation (34) des signaux d'entrée du comparateur de phase pouvant être réalisé avec des bascules D, permettant l'utilisation du signal d'information de direction et de couple/vitesse (6) avec un rapport cyclique variable pouvant se rapprocher des valeurs extrêmes.

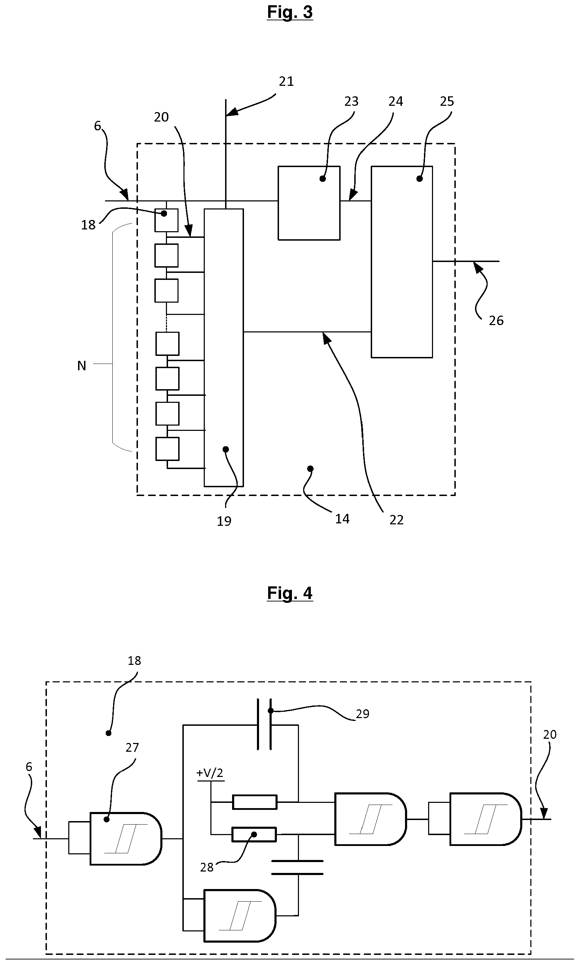

Figure 3 est représenté un second exemple de réalisation du multiplicateur fréquentiel (14) avec 7 modules élémentaires (18), permettant à chaque étage de multiplier la fréquence de son signal d'entrée et de transmettre le dit signal multiplié avec un rapport cyclique fixé à une valeur, typiquement 50%, à un multiplexeur (19) permettant de sélectionner grâce à la tension de commande (21) le signal d'entrée, par exemple (20), à transmettre sur la sortie du multiplexeur (22). Il est également composé d'un module d'extraction (23) du rapport cyclique du signal d'information de direction et de couple/vitesse (6), transmettant l'information de rapport cyclique (24) au bon format (analogique par exemple) au module de génération du signal MLI à haute fréquence (25), ce dernier combinant la nouvelle fréquence élevée sortie du multiplexeur (22) avec le rapport cyclique (24) sur le signal d'information haute fréquence de direction et de couple/vitesse (26) du multiplicateur fréquentiel (14). Les facteurs de multiplications possibles sont donc de $X^N$, « N » étant le nombre de modules élémentaires (18) multiplicateurs de fréquences intégrés.

Il est possible de citer comme exemple la multiplication fréquentielle nécessaire à l'application de déphaseur d'arbre à cames (eVCP) pour laquelle 7 modules élémentaires (18) multiplicateurs de fréquence avec un facteur X=2 suffisent pour pouvoir multiplier une fréquence d'entrée du signal d'information de direction et de couple/vitesse (6) de 200Hz avec un facteur 128, afin d'obtenir un signal de sortie du multiplexeur (22) de l'ordre de 25'600Hz. La fréquence de ce signal de sortie du multiplexeur (22) est directement transposée au signal d'information haute fréquence de direction et de couple/vitesse (26) du module multiplicateur de fréquence (14) et peut être ajustée par l'intermédiaire de la tension de commande (21) afin d'optimiser la fréquence de contrôle des transistors composant le pont de puissance (13), cette dernière étant l'image de la fréquence du signal (26) de sortie du multiplicateur fréquentiel. L'optimisation de la fréquence du signal (26) de sortie du multiplicateur fréquentiel a pour effet de diminuer les pertes par commutations dans le dit pont tout en garantissant un contrôle des transistors à une fréquence au-delà de la bande fréquentielle audible.

Figure 4 est représenté le schéma de principe d'une solution de réalisation du module élémentaire (18) permettant de multiplier la fréquence d'un signal d'information de direction et de couple/vitesse (6) rectangulaire par un facteur X=2 à base de portes logiques NON-OU (également nommées NOR) (27), de résistances (28) et de capacités (29) de faibles valeurs.

## Description détaillée de la modulation de l'information de retour de sens de rotation et de l'information de vitesse (ou position relative)

La description qui suit concerne une variante particulière, relative à la modulation de l'information de sens de rotation et de l'information de vitesse de rotation (ou position relative) du moteur BLDC (8), compatible avec toute solution de pilotage moteur réalisé par des blocs matériels sans calculateur, logiciel ou mémoire. Par convention, l'information de sens de rotation est nommée « information de direction », ou « direction ».

Dans le cas d'une application avec un asservissement du moteur BLDC(8) de l'ensemble mécatronique (2) par l'unité de contrôle électronique (1) intégrant un régulateur, par exemple de type proportionnel et intégrateur « PI », il est possible de coupler au circuit électronique de pilotage (10) un circuit électronique de modulation circuit électronique de modulation (15) mesurant la vitesse de rotation, détectant le sens de rotation du moteur BLDC (8) et modulant ces deux signaux afin de fournir une seule information de signal électrique numérique unidirectionnel (17) codée via l'interface de connexion (3). De tels moyens peuvent être agencés comme indiqué en figure 1.

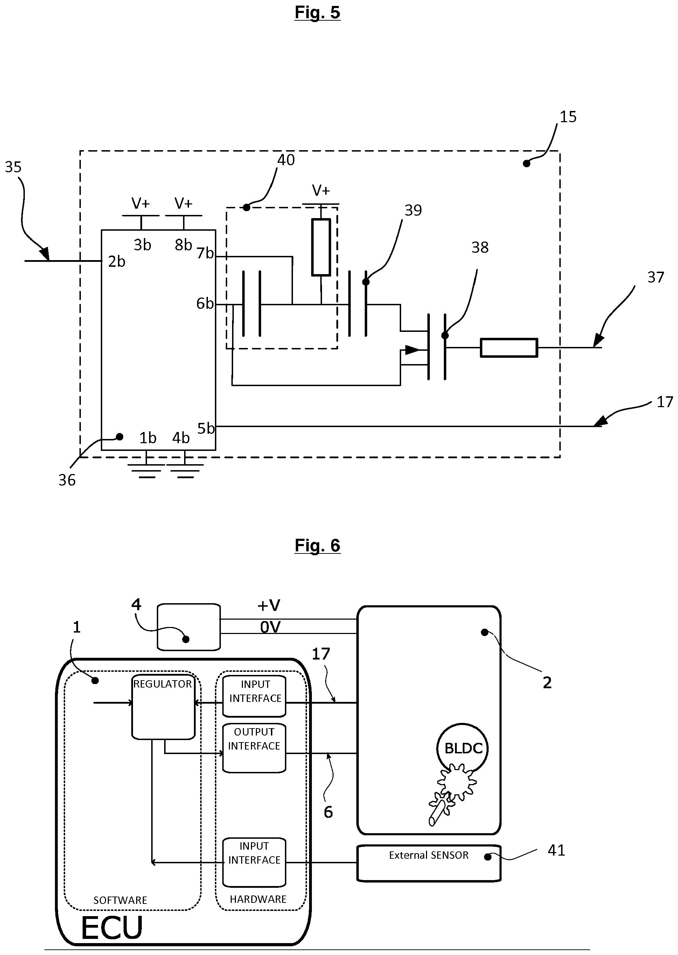

Figure 5 est représenté une solution matérielle sans logiciel, calculateur et mémoire permettant de réaliser la modulation en largeur d'impulsion des signaux de vitesse et de sens de rotation du moteur BLDC (8). Le but des modulations numériques du type MLI est d'assurer un débit maximum de données binaires, avec un taux d'erreur acceptable par les protocoles et le correcteur amont. Dans l'empilement des protocoles OSI (architecture standard des télécommunications numériques), la modulation est l'élément principal de la couche physique. Ainsi, lors des flancs montants du signal de vitesse (35) qui est sous la forme d'un signal créneau numérique de rapport cyclique de 50%, une impulsion est générée sur le signal électrique numérique unidirectionnel (17), dont la durée est constante et indépendante de la fréquence du signal de vitesse (35), considérée comme la fréquence porteuse de la modulation. Cette impulsion peut être réalisée avec une bascule monostable (36). Le monostable choisi en exemple est SN74LVC1G123 ou 74LVC1G1236-Q100. La durée d'impulsion est imposée par la constante de temps du filtre RC (40) placé en externe et connectée aux broches 6b et 7b. Lorsque le signal de direction (37) vaut 0 (sens antihoraire), le MOSFET (38) est non passant, la base de temps du monostable est donc fonction uniquement du circuit RC (40). Lorsque le signal de direction (37) vaut 1 (sens horaire), le MOSFET (38) conduit ajoutant la capacité (39) au module RC (40) ; la capacité totale augmente la constante de temps et donc augmente la durée d'impulsion TON. La broche 6b du monostable doit être reliée à la masse pour une commutation du MOSFET correcte, ce qui est le cas sur le monostable choisi. Ce type de circuit électronique de modulation (15) permet de synchroniser l'information de changement de direction (37) avec l'information de vitesse (35), utilisée comme la fréquence porteuse.

La figure 6 illustre la compatibilité matérielle d'un ensemble mécatronique (2) intégrant un circuit électronique de modulation (15) de modulation des informations de vitesse (35) et de direction (37) en un signal unique électrique numérique unidirectionnel (17) et d'une unité de contrôle électronique (1) existant ne nécessitant pas l'information de direction, puisque ce dernier reçoit cette information d'un capteur externe (41) au système décrit, ou parce que la direction ne s'inverse jamais lors de l'utilisation de l'ensemble dans l'application (fonctionnement d'une pompe électrique par exemple). Dans ce cas, l'information de vitesse contenue dans le signal (17) est extraite par l'unité de contrôle électronique (1) sans aucune adaptation matérielle ou logicielle de ce dernier, l'information de direction est simplement ignorée et sans effets. L'unité de contrôle électronique (1) peut connaître la vitesse du moteur BLDC en mesurant la période entre chaque front montant du signal (17). L'information de direction, quant à elle, contenue par mesure de l'état haut du signal (17) n'est pas démodulée et est donc invisible ou transparente au unité de contrôle électronique (1) qui gère le signal (17) comme un signal numérique carré de rapport cyclique 50%.

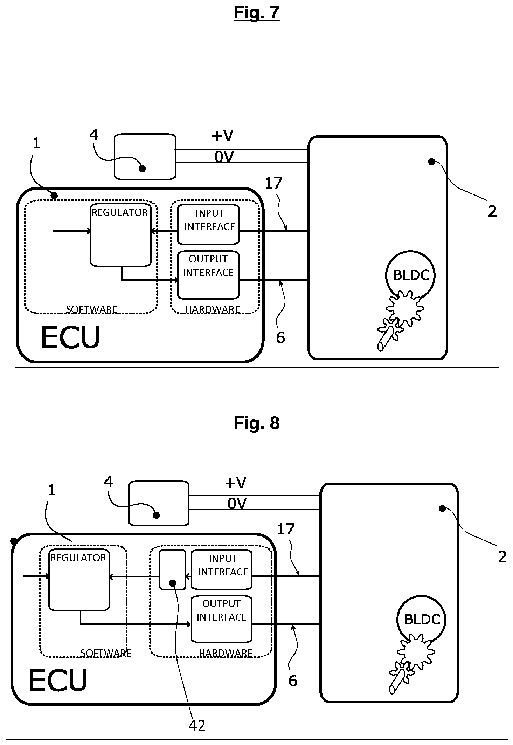

Les figures 7 et 8 illustrent la compatibilité matérielle d'un ensemble mécatronique (2) intégrant un circuit électronique de modulation (15) de modulation des informations de vitesse (35) et de direction (37) en un signal unique (17) et d'une unité de contrôle électronique (1) existant nécessitant les deux types de signaux, soit vitesse et direction, pour asservir correctement le moteur BLDC (8).

Figure 7, les informations de direction et de vitesses doivent être compréhensibles pour l'unité de contrôle électronique (1) avec une adaptation logicielle uniquement, sans aucune adaptation matérielle de l'interface d'entrée. Dans ce cas, le signal (17) sera démodulé et décodé dans la nouvelle fonction logicielle intégrée dans l'unité de contrôle électronique (1), de façon préférentielle mais non limitative par la génération d'une interruption sur chaque front montant du signal (17) déclenchant un compteur interne avec une période faible. A chaque incrément du compteur, le niveau du signal (17) est vérifié pour permettre de mesurer la durée de l'impulsion à l'état haut, puisqu'elle contient l'information de direction. L'incrément du compteur est stoppé et la valeur lue à la prochaine interruption liée au prochain front montant du signal (17) ; ce qui permet de connaitre la période du signal (17), donc l'information de vitesse de rotation du moteur (8). Alors, le compteur est réinitialisé et le cycle décrit est réitéré.

Figure 8, les informations de direction et de vitesses doivent être compréhensibles pour l'unité de contrôle électronique (1) avec une adaptation matérielle uniquement. Dans ce cas, le signal (17) sera démodulé et décodé par un module complémentaire (42) à rajouter dans l'unité de contrôle électronique (1) pour en extraire l'information de direction (pouvant être réalisé avec un ou plusieurs comparateurs à base d'amplificateurs opérationnels avec des seuils différents permettant de détecter les deux directions) et l'information de vitesse (pouvant être réalisé avec un circuit de transformation d'une fréquence de signal numérique en un signal analogique à tension variable, comme le circuit LM2907).

Un autre type d'architecture est la démodulation et le décodage du signal (17) par combinaison de solutions logicielles et matérielles.

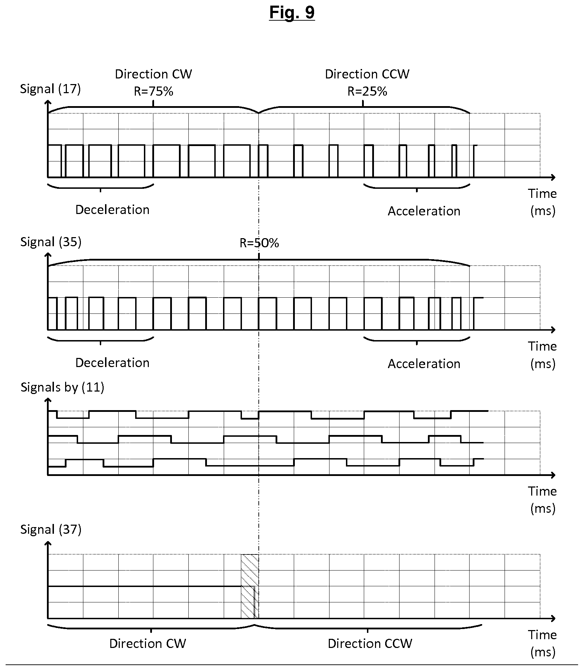

La figure 9 illustre la solution de modulation à largeur d'impulsion effectuée par le circuit électronique de modulation (15) lors d'un changement de direction. La fréquence du signal modulé (17) garde la même période électrique que l'information de vitesse (35) y compris pendant les phases d'accélération et de décélération. Les fronts montants du signal modulé (17) sont synchrones des fronts montants du signal de vitesse (35). Cela permet de mettre en évidence que l'information de vitesse est identique pour l'unité de contrôle électronique (1) s'il respecte la condition de ne prendre en compte qu'un seul type de transition (préférentiellement le front montant pour un niveau récessif du signal à tension nulle) pour déterminer l'image de la vitesse. Le rapport cyclique du signal modulé (17) représenté dans la figure 9, et exprimé en % et noté $R_{17}$, peut prendre deux valeurs distinctes définies par le sens de rotation du moteur (également nommé information de direction). Ces deux valeurs de rapport cyclique seront suffisamment différentes pour éviter toute erreur. A titre d'exemple, pour la direction dite anti horaire, le rapport cyclique du signal modulé (17) sera à l'état haut pendant 25% de la période électrique, soit $R_{17}=25\%$ et pour la direction dite horaire, le rapport cyclique du signal modulé (17) sera à l'état haut pendant 75% de la période électrique, soit $R_{17}=75\%$. Il est possible de configurer le signal modulé (17) par un jeux de composants passifs simples et bons marchés pour déterminer le rapport entre la fréquence électrique du signal (17) égale, par défaut, à ½ de la fréquence d'un phaseur donné par les éléments de Hall (11), fonction du nombre de phases et du nombre de pôles rotor et la fréquence mécanique du rotor, en cas de contrôle trapézoïdal. Ce rapport pourra permettre de diviser la fréquence des signaux générés par les sondes de Hall (11), dont l'image est le signal (35), afin d'avoir directement la fréquence rotorique, donc de l'axe du moteur BLDC (8) ou de l'axe de sortie de l'ensemble mécatronique (2) s'il intègre un étage de réduction mécanique. La figure 9 met en évidence la synchronisation des informations de vitesse et de changement de direction. Suivant la conception matérielle du circuit électronique de pilotage (10) supportant la fonction de détermination de la direction et générant le signal (37), un retard non déterministe existe, ce qui rend possible le changement d'état du signal (37) de manière aléatoire pendant une période électrique du signal (35), donc pendant un des six pas électrique du moteur BLDC (8), en cas de contrôle trapézoïdal, défini par la zone hachurée. Or, l'information de changement de direction est transmise à l'unité de contrôle électronique (1) de manière synchrone au travers du changement de rapport cyclique du signal (17) sur la période électrique suivante (donc du premier pas électrique du rotor dans le nouveau sens de rotation). Cette resynchronisation permet de rendre négligeable toute erreur d'interprétation de l'information de vitesse (ou de position relative), surtout pour les applications à très forte dynamique ou le changement de direction est très rapide. Cette solution permet pour un cout très modeste de :

- réduire la taille du connecteur en supprimant une connexion électrique.
- supprimer un fil de signal sur le faisceau électrique.
- améliorer la robustesse de l'interprétation des informations vitesse (35) (ou position absolue) et direction (37) par l'unité de contrôle électronique (1) au moment du changement de sens de rotation.
- rester compatible avec les architectures matérielles ECU (1) existantes.
- démoduler le signal (17) en utilisant une fonction logicielle existante dans les contrôleurs (1) et utiliser communément pour vérifier les signaux de commandes des moteurs DC à balais (dans le cas de l'utilisation de la modulation MLI).
- donner l'opportunité de multiplier les rapports cycliques utilisables du signal modulé (17) afin de transmettre au contrôleur des erreurs internes à l'ensemble mécatronique (2), ou tout autre type d'information ou de diagnostic.

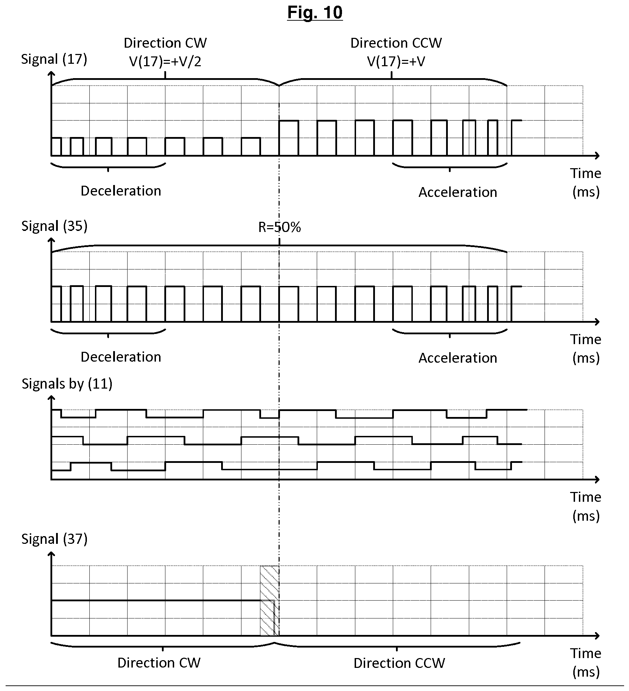

La figure 10 représente la solution de modulation d'amplitude du signal (17). Les principes généraux sont communs à la solution de modulation à largeur d'impulsion, excepté que le rapport cyclique du signal modulé $R_{17}$ est fixe, préférentiellement égal à 50%. Le signal modulé (17) est synchrone du signal de vitesse (35). L'amplitude du signal modulé (17) exprimé en volt peut prendre deux valeurs forcées par l'état de l'information de direction (37). Ces deux valeurs d'amplitude seront suffisamment différentes pour éviter toute erreur de lecture par l'unité de contrôle électronique (1). A titre d'exemple, pour la direction dite anti horaire l'amplitude du signal modulé (17) vaudra 100% de la tension d'alimentation fournit par la source de puissance (4) soit +V ; pour la direction dite horaire, l'amplitude du signal modulé (17) vaudra 50% de la tension d'alimentation, fournit par la source de puissance (4), soit (+V)/2.

## Description détaillée pour la gestion de l'énergie transmise au moteur

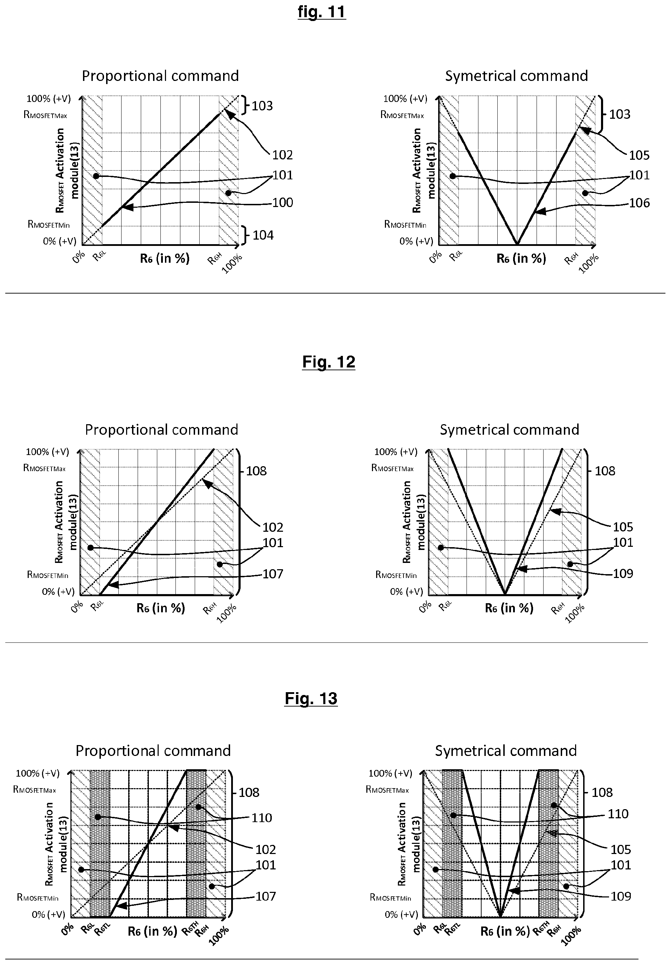

La figure 11 illustre les deux stratégies de commandes de ponts traditionnellement implémentées dans les circuits électroniques de pilotage, ou « drivers » (10) de l'état de l'art pour piloter un ensemble mécatronique (2) en fonction des stratégies de contrôle des contrôleurs (1) via un signal d'information de direction et de couple/vitesse (6) modulé en largeur d'impulsion.

Dans le cas d'un contrôle type « slow decay », à gauche en figure 11, le rapport cyclique $R_6$ du signal (6) est reporté proportionnellement par le circuit électronique de pilotage, (10) avec un gain unitaire sur les signaux de commande des transistors composants le pont de puissance (13) et permettant d'effectuer un contrôle en tension du moteur BLDC (8). Ainsi, le rapport cyclique, noté $R_{MOSFET}$, appliqué sur une partie des transistors du pont de puissance, est égal au rapport cyclique, $R_6$, du signal d'information de direction et de couple/vitesse (6), soit : $R_{MOSFET} = R_6$.

Dans le cas d'un contrôle type « synchrone », à droite sur la figure 12, le rapport cyclique $R_6$ du signal d'information de direction et de couple/vitesse (6) est reporté symétriquement par le circuit électronique de pilotage, (10) avec un gain unitaire sur les signaux de commande des transistors composants le pont de puissance (13) et permettant d'effectuer un contrôle en tension du moteur BLDC (8). $R_{MOSFET} = |2 \times (R_6 - 50)|$. Dans le cas d'un contrôle type

$$\overline{R_{MOSFET}} = 1/R_{MOSFET}$$

« synchrone », le rapport cyclique inverse, est appliqué aux transistors de la cellule opposée.

La protection de l'application, contre les défauts électriques pouvant apparaitre sur la ligne d'information de direction et de couple/vitesse (6) entre l'unité de contrôle électronique (1) et le connecteur (3), impose la mise en place de deux zones (101), dites «zones mortes», non utilisables par l'unité de contrôle électronique (1) pour piloter l'ensemble mécatronique (2). Ces deux zones (101) permettent à l'unité de contrôle électronique (1) et / ou à l'ensemble mécatronique (2) de détecter les courts circuits de la ligne d'information de direction et de couple/vitesse (6) à la masse (noté 0V) ou à l'alimentation (noté +V) ainsi qu'une coupure de cette ligne d'information de direction et de couple/vitesse (6).

Dans le cas d'une commande dite proportionnelle, l'unité de contrôle électronique (1) génère un signal d'information de direction et de couple/vitesse (6) sur la plage (100), caractérisée en ce que l'énergie transmise au moteur soit directement proportionnelle au rapport cyclique du signal d'information de direction et de couple/vitesse (6); la première zone non utilisable (101), ayant pour limite supérieure le rapport cyclique minimal $R_{6L}$ que peut transmettre l'unité de contrôle électronique (1), induit l'impossibilité pour le pont de puissance (13) de contrôler en tension le moteur BLDC (8) sur toute la plage théorique (102), soit avec des valeurs efficaces de tension comprises entre $R_{MOSFETMin} = R_{6L} \times (+V)$ et $(0V)$ et définie par la plage (104). La zone (104) non utilisable, délimitée par le rapport cyclique minimal $R_{6L}$, dans le cas d'une commande dite proportionnelle pour le contrôle de l'ensemble mécatronique (2) ne permet pas de transmettre peu d'énergie au moteur BLDC, ce qui peut être problématique pour les applications de type contrôle de vanne avec peu de friction, afin de prévenir toute erreur statique du système asservi.

La seconde zone non utilisable (101), ayant pour limite inférieure le rapport cyclique maximal $R_{6H}$ que peut transmettre l'unité de contrôle électronique (1), induit l'impossibilité pour le pont de puissance (13) de contrôler en tension le moteur BLDC (8) avec des valeurs efficaces de tension comprises entre $R_{MOSFETMax} = R_{6H} \times (+V)$ et $(+V)$ et définie par la plage (103).

Dans le cas d'une commande dite symétrique (ou pilotage synchrone), l'unité de contrôle électronique (1) génère un signal d'information de direction et de couple/vitesse (6) sur la plage (106), caractérisée en ce que l'énergie transmise au moteur soit nulle pour un rapport cyclique du signal d'information de direction et de couple/vitesse (6) valant 50%; les deux zones non utilisables (101), ayant pour limites inférieures les rapports cycliques $R_{6L}$ et $R_{6H}$ que peut transmettre l'unité de contrôle électronique (1), induit l'impossibilité pour le pont de puissance (13) de contrôler en tension le moteur BLDC (8)) sur toute la plage théorique (105), soit avec des valeurs efficaces de tension comprises entre $R_{MOSFETMax} = 12 \times (R_{6H} - 50)| \times (+V)$, $R_{MOSFETMax} = |2 \times (R_{6L} - 50)| \times (+V)$ et $(+V)$ et définie par la plage (103). La zone (103) non utilisable, délimitée par les rapports cycliques minimaux $R_{6L}$ ou maximaux $R_{6H}$, pour le contrôle de l'ensemble mécatronique (2) limite intrinsèquement l'énergie électrique maximum transmissible au moteur BLDC (8).

La figure 12 illustre l'invention caractérisée en ce que le circuit électronique de pilotage, (10), contrôle les transistors composant le pont de puissance (13) avec un rapport cyclique $R_{MOSFET}$ en fonction des valeurs du rapport cyclique du signal d'information de direction et de couple/vitesse (6), nommé $R_6$, en suivant les formules suivantes.

Pour une commande dite proportionnelle, à gauche en figure 12 :

$$R_{MOSFET} = R_6 \times \frac{100}{R_{6H} - R_{6L}} + (100 - \frac{100}{R_{6H} - R_{6L}} \times R_{6H})$$

La courbe (107) illustre cette équation.

Pour une commande dite symétrique, à droite en figure 12:

$$R_{MOSFET} = -(R_6 \times \frac{100}{50 - R_{6L}}) + (100 + \frac{100}{50 - R_{6L}} \times R_{6L})$$

Pour $R_6 < 50\%$ :

$$R_{MOSFET} = R_6 \times \frac{100}{R_{6H} - 50} + (100 - \frac{100}{R_{6H} - 50} \times R_{6H})$$

Pour $R_6 \geq 50\%$ :

La courbe (109) illustre cette équation.

Le signal d'information de direction et de couple/vitesse (6) généré par l'unité de contrôle électronique (1) reste identique à l'état de l'art, en gardant les spécificités de maximum et minimum de rapport cyclique notés $R_{6L}$ et $R_{6H}$ garantissant la détection de défaut électrique sur la ligne d'information de direction et de couple/vitesse (6). L'énergie électrique (108) transmissible au moteur BLDC (8) par le pont de puissance (13), dont l'image pour un contrôle en tension en commande trapézoïdale est le rapport cyclique appliqué à la tension d'alimentation +V dans chacun des 6 phaseurs spatiaux (pour un moteur triphasé) est à même de varier entre 0%x(+V) et 100%x(+V), supprimant les zones mortes (103) et (104) et les inconvénients liés à ces dernières.

Pour certaines applications, il est recommandé d'ajouter des zones où 100% de la puissance sera appliquée au moteur (zone 110). Ces zones seront comprises entre le rapport cyclique $R_{6Th}$ et le rapport cyclique maximal avant la zone morte haute $R_{6h}$ ainsi que le rapport cyclique $R_{6TL}$ et le rapport cyclique minimal d'utilisation $R_{6L}$ avant la zone morte basse. L'application de ces zones permettra de s'assurer que 0% et 100% de la puissance peuvent être appliqués sans pour autant passer en zone morte.

## Revendications

**1.** Ensemble mécatronique (2) pour l'entrainement d'un organe destiné à être relié d'une part à une source électrique continue de puissance (4) et d'autre part à une unité de contrôle électronique (1) comprenant un calculateur pour l'exécution d'un algorithme d'asservissement délivrant un signal d'entrée à modulation de largeur d'impulsion présentant des états discrets et un rapport cyclique codant les informations de direction et de couple/vitesse (6), ledit ensemble (2) comprenant un moteur électrique sans balai (8) polyphasé à P phases, où P > 1, des sondes (11) de détection binaires de la position du rotor dudit moteur (8), un pont de puissance (13) pour l'alimentation des P phases du moteur (8), et un circuit électronique de pilotage embarqué (10) dont la sortie commande ledit pont de puissance (13) assurant l'auto-commutation du moteur (8) en combinant les informations en provenance du signal de direction et de couple/vitesse (6), des sondes (11) de détection binaires de la position du rotor et d'une logique de commutation modulant directement le courant de la source électrique continue de puissance (4) appliquée à chacune desdites phases du moteur (8), l'information de direction et de couple/vitesse (6) fournie par l'unité de contrôle électronique (1) étant distincte du signal de puissance délivré seulement par la source de puissance (4), **caractérisé en ce qu'**il comporte un multiplicateur fréquentiel (14) placé en amont du circuit électronique de pilotage (10) et produisant pour chaque état discret dudit signal d'entrée (6) $X^N$ états discrets d'information haute fréquence de direction et de couple/vitesse (26) présentant le même rapport cyclique que l'état discret d'entrée, d'une durée $X^N$ fois inférieure à la durée de l'état discret du signal d'entrée, où X et N sont des entiers $\geq 1$, et dont la fréquence de sortie est supérieure ou égale à la fréquence électrique des phaseurs spatiaux du moteur (8) piloté.

2. Ensemble mécatronique (2) selon la revendication 1 **caractérisé en ce que** le circuit électronique de pilotage embarqué (10) est exempt de microcontrôleur, calculateur et de mémoire.

3. Ensemble mécatronique (2) selon la revendication 1 **caractérisé en ce que** X vaut 2.

4. Ensemble mécatronique (2) selon la revendication 1 **caractérisé en ce que** ledit multiplicateur fréquentiel (14) comprend un module de boucle à verrouillage de phase.

5. Ensemble mécatronique (2) selon la revendication 1 **caractérisé en ce que** le multiplicateur fréquentiel (14) comprend un circuit électronique multiplicateur de fréquence composé de N modules élémentaires multiplicateurs de fréquences (18) permettant à chaque étage de multiplier la fréquence de son signal d'entrée et de transmettre le dit signal multiplié 26 au circuit électronique de pilotage embarqué (10).

6. Ensemble mécatronique (2) selon l'une quelconque des revendications 1 à 5 **caractérisé en ce que** ledit circuit électronique de pilotage embarqué (10) comprend un circuit électronique de modulation (15) qui génère un signal électrique numérique unidirectionnel (17) modulé présentant des états discrets codés.

7. Ensemble mécatronique (2) selon la revendication précédente **caractérisée en ce que** ledit circuit électronique de modulation (15) code ledit signal modulé (17) en fonction de la direction du moteur.

8. Ensemble mécatronique (2) selon la revendication 6 **caractérisé en ce que** ledit circuit électronique de modulation (15) code ledit signal modulé en fonction de la vitesse de rotation du moteur.

9. Ensemble mécatronique (2) selon la revendication 7 **caractérisé en ce que** ledit circuit électronique de modulation (15) module en largeur d'impulsion le signal (17) et code le rapport cyclique de chaque état discret.

10. Ensemble mécatronique (2) selon la revendication 7 **caractérisé en ce que** ledit circuit électronique de modulation (15) module en amplitude le signal (17) et code l'amplitude du niveau haut de chaque état discret avec un rapport cyclique fixe.

11. Ensemble mécatronique (2) selon la revendication 7 **caractérisé en ce que** ledit circuit électronique de modulation (15) module en fréquence le signal (17) et code la fréquence.

12. Ensemble mécatronique (2) selon la revendication 6 **caractérisé en ce que** ledit circuit électronique de modulation (15) code l'amplitude du niveau haut de chaque état discret en fonction d'une première information, le rapport cyclique en fonction d'une deuxième information et la fréquence en fonction d'une troisième information.

13. Ensemble mécatronique (2) selon la revendication 1 **caractérisé en ce que** ledit circuit électronique de pilotage embarqué (10) comprend un adaptateur d'impédance (16) qui applique une tension à chacun des phaseurs spatiaux

$$R_{MOSFET} = R_6 \times \frac{100}{R_{6H}-R_{6L}} + \left(100 - \frac{100}{R_{6H}-R_{6L}} \times R_{6H}\right)$$

selon le rapport cyclique où R6 désigne le rapport cyclique du signal de commande issu du contrôleur externe, $R_{6H}$ désigne la limite haute du rapport cyclique transmissible par le contrôleur externe, $R_{6L}$ désigne la limite basse du rapport cyclique transmissible par le contrôleur externe.

14. Ensemble mécatronique (2) selon la revendication 1 **caractérisé en ce que** ledit circuit électronique de pilotage embarqué (10) comprend un adaptateur d'impédance (16) qui applique une tension à chacun des phaseurs spatiaux

$$R_{MOSFET} = -(R_6 \times \frac{100}{50-R_{6L}}) + (100 + \frac{100}{50-R_{6L}} \times R_{6L})$$

selon le rapport cyclique ... lorsque R₆ est inférieur

$$R_{MOSFET} = R_6 \times \frac{100}{R_{6H}-50} + (100 - \frac{100}{R_{6H}-50} \times R_{6H})$$

à 50% et ... lorsque $R_6$ est supérieur ou égal à 50% ; ou $R_6$ désigne le rapport cyclique du signal de commande issu du contrôleur externe, $R_{6H}$ désigne la limite haute du rapport cyclique transmissible par le contrôleur externe, $R_{6L}$ désigne la limite basse du rapport cyclique transmissible par le contrôleur externe.

**15.** Ensemble mécatronique (2) selon la revendication 13 ou 14 **caractérisé en ce que** ladite unité de commande ECU (1) détermine un rapport cyclique $R_6$ inférieur à $R_{6L}$ ou supérieur à $R_{6H}$ pour commander un mode de protection.

**16.** Ensemble mécatronique (2) selon la revendication 1 **caractérisé en ce que** N varie en fonction du régime du moteur.

**Patentansprüche**

**1.** Mechatronische Baugruppe (2) zum Antrieb eines Elements, das dazu bestimmt ist, einerseits an eine elektrische Gleichstromquelle (4) und andererseits an eine elektronische Steuereinheit (1) angeschlossen zu werden, die einen Rechner zur Ausführung eines Servoalgorithmus umfasst, der ein pulsbreitenmoduliertes Eingangssignal mit diskreten Zuständen und einem Tastverhältnis liefert, das die Richtungs- und Drehmoment-/Geschwindigkeitsinformationen (6) codiert, wobei die Baugruppe (2) einen mehrphasigen bürstenlosen Elektromotor (8) mit P Phasen, wobei P > 1 ist, Sonden (11) zur binären Erfassung der Position des Rotors des Motors (8), eine Leistungsbrücke (13) zur Versorgung der P Phasen des Motors (8) und eine elektronische Bordsteuerschaltung (10) umfasst, deren Ausgang die Leistungsbrücke (13) steuert, die die Selbstumschaltung des Motors (8) durch Kombination der Informationen aus dem Richtungs- und dem Drehmoment-/Geschwindigkeitssignal (6) sicherstellt, Sonden (11) zur binären Erfassung der Rotorposition und einer Schaltlogik, die den Strom der Gleichstromquelle (4) direkt modulieren, die an jede der genannten Phasen des Motors (8) angelegt wird, wobei sich die von der elektronischen Steuereinheit (1) gelieferten Richtungs- und Drehmoment-/Geschwindigkeitsinformationen (6) von dem nur von der Stromquelle (4) gelieferten Leistungssignal unterscheiden, **dadurch gekennzeichnet, dass** sie einen Frequenzvervielfacher (14) umfasst, der vor der elektronischen Steuerschaltung (10) angeordnet ist und für jeden diskreten Zustand des Eingangssignals (6) $X^N$ diskrete Informationszustände (26) über Richtung und Drehmoment/Geschwindigkeit der Hochfrequenz erzeugt, die das gleiche Tastverhältnis wie der diskrete Eingangszustand haben, mit einer Dauer, die $X^N$-mal kürzer ist als die Dauer des diskreten Zustands des Eingangssignals, wobei X und N ganze Zahlen ≥ 1 sind und deren Ausgangsfrequenz größer oder gleich der elektrischen Frequenz der Raumphaser des gesteuerten Motors (8) ist.

**2.** Mechatronische Baugruppe (2) nach Anspruch 1, **dadurch gekennzeichnet, dass** die elektronische Bordsteuerschaltung (10) keinen Mikrocontroller, Rechner und Speicher aufweist.

**3.** Mechatronische Baugruppe (2) nach Anspruch 1, **dadurch gekennzeichnet, dass** X gleich 2 ist.

**4.** Mechatronische Baugruppe (2) nach Anspruch 1, **dadurch gekennzeichnet, dass** der Frequenzvervielfacher (14) ein Phasenregelkreismodul umfasst.

**5.** Mechatronische Baugruppe (2) nach Anspruch 1, **dadurch gekennzeichnet, dass** der Frequenzvervielfacher (14) eine elektronische Frequenzvervielfacher-Schaltung umfasst, die aus N elementaren Frequenzvervielfacher-Modulen (18) besteht, mit denen jede Stufe die Frequenz ihres Eingangssignals vervielfachen und das vervielfachte Signal (26) an die elektronische Bordsteuerschaltung (10) übertragen kann.

**6.** Mechatronische Baugruppe (2) nach einem der Ansprüche 1 bis 5, **dadurch gekennzeichnet, dass** die elektronische Bordsteuerschaltung (10) eine elektronische Modulationsschaltung (15) umfasst, die ein moduliertes unidirektionales digitales elektrisches Signal (17) mit diskreten codierten Zuständen erzeugt.

**7.** Mechatronische Baugruppe (2) nach dem vorhergehenden Anspruch, **dadurch gekennzeichnet, dass** die elektronische Modulationsschaltung (15) das modulierte Signal (17) in Abhängigkeit von der Richtung des Motors codiert.

8. Mechatronische Baugruppe (2) nach Anspruch 6, **dadurch gekennzeichnet, dass** die elektronische Modulationsschaltung (15) das modulierte Signal in Abhängigkeit von der Drehgeschwindigkeit des Motors codiert.

9. Mechatronische Baugruppe (2) nach Anspruch 7, **dadurch gekennzeichnet, dass** die elektronische Modulationsschaltung (15) das Signal (17) in der Pulsbreite moduliert und das Tastverhältnis jedes diskreten Zustands kodiert.

10. Mechatronische Baugruppe (2) nach Anspruch 7, **dadurch gekennzeichnet, dass** die elektronische Modulationsschaltung (15) das Signal (17) in der Amplitude moduliert und die Amplitude des hohen Pegels jedes diskreten Zustands mit einem festen Tastverhältnis codiert.

11. Mechatronische Baugruppe (2) nach Anspruch 7, **dadurch gekennzeichnet, dass** die elektronische Modulationsschaltung (15) das Signal (17) in der Frequenz moduliert und die Frequenz codiert.

12. Mechatronische Baugruppe (2) nach Anspruch 6, **dadurch gekennzeichnet, dass** die elektronische Modulationsschaltung (15) die Amplitude des hohen Pegels jedes diskreten Zustands in Abhängigkeit von einer ersten Information, das Tastverhältnis in Abhängigkeit von einer zweiten Information sowie die Frequenz in Abhängigkeit von einer dritten Information codiert.

13. Mechatronische Baugruppe (2) nach Anspruch 1, **dadurch gekennzeichnet, dass** die elektronische Bordsteuerschaltung (10) einen Impedanzadapter (16) umfasst, der eine Spannung an jeden der Raumphaser entsprechend dem Tastverhältnis anlegt, $R_{MOSFET} = R_6 \times \frac{100}{R_{6H}-R_{6L}} + \left(100 - \frac{100}{R_{6H}-R_{6L}} \times R_{6H}\right)$ wobei $R_6$ das Tastverhältnis des Steuersignals von der externen Steuerung angibt, $R_{6h}$ die Obergrenze des durch die externe Steuerung übertragbaren Tastverhältnisses angibt und $R_{6L}$ die Untergrenze des durch die externe Steuerung übertragbaren Tastverhältnisses angibt.

14. Mechatronische Baugruppe (2) nach Anspruch 1, **dadurch gekennzeichnet, dass** die elektronische Bordsteuerschaltung (10) einen Impedanzadapter (16) umfasst, der eine Spannung an jeden der Raumphaser entsprechend dem Tastverhältnis anlegt, $R_{MOSFET} = -\left(R_6 \times \frac{100}{50-R_{6L}}\right) + \left(100 + \frac{100}{50-R_{6L}} \times R_{6L}\right)$ wenn $R_6$ kleiner als 50 %

ist und $R_{MOSFET} = R_6 \times \frac{100}{R_{6H}-50} + \left(100 - \frac{100}{R_{6H}-50} \times R_{6H}\right)$ wenn $R_6$ größer oder gleich 50 % ist;
wobei $R_6$ das Tastverhältnis des Steuersignals von der externen Steuerung angibt, $R_{6H}$ die Obergrenze des von der externen Steuerung übertragbaren Tastverhältnisses angibt und $R_{6L}$ die Untergrenze des von der externen Steuerung übertragbaren Tastverhältnisses angibt.

15. Mechatronische Baugruppe (2) nach Anspruch 13 oder 14, **dadurch gekennzeichnet, dass** die ECU-Steuereinheit (1) ein Tastverhältnis $R_6$ kleiner als $R_{6L}$ ODER größer als $R_{6H}$ bestimmt, um einen Schutzmodus zu steuern.

16. Mechatronische Baugruppe (2) nach Anspruch 1, **dadurch gekennzeichnet, dass** N in Abhängigkeit von der Motordrehzahl variiert.

**Claims**

1. Mechatronic assembly (2) for driving a member intended to be connected on the one hand to a continuous electric power source (4) and on the other hand to an electronic control unit (1) comprising a computer for the execution of a servo algorithm outputting a pulse width modulation input signal having discrete states and a duty cycle encoding the direction and torque/speed information (6), said assembly (2) comprising a polyphase brushless electric motor (8) having P phases, where P > 1, binary sensors (11) for detecting the position of the rotor of said motor (8), a power bridge (13) for supplying the P phases of the motor (8), and an on-board electronic control circuit (10), the output of which controls said power bridge (13) ensuring the self-switching of the motor (8) by combining the information coming from the direction and torque/speed signal (6), binary sensors (11) for detecting the rotor position and a switching logic directly modulating the current of the continuous electric power source (4) applied to each of said phases of the motor (8), the direction and torque/speed information (6) provided by the electronic control unit (1) being separate from the power signal outputted only by the power source (4), **characterized in that** said mechatronic assembly comprises a frequency multiplier (14) placed upstream of the electronic control circuit (10) and producing, for each discrete state of said input signal (6), $X^N$ high-frequency discrete states of direction and torque/speed information (26) having the same duty cycle as the discrete input state, of duration $X^N$ times less than the duration of the discrete state of the input signal, where X and N are integers $\geq 1$, and the output frequency of which is greater than or equal to the electric frequency of the spatial phasers of the controlled motor (8).

2. Mechatronic assembly (2) according to claim 1, **characterized in that** the on-board electronic control circuit (10) is free of microcontrollers, computers and memory.

3. Mechatronic assembly (2) according to claim 1, **characterized in that** X is equal to 2.

4. Mechatronic assembly (2) according to claim 1, **characterized in that** said frequency multiplier (14) comprises a phase-locked loop module.

5. Mechatronic assembly (2) according to claim 1, **characterized in that** the frequency multiplier (14) comprises an electronic frequency-multiplier circuit composed of N elementary frequency-multiplier modules (18) allowing each stage to multiply the frequency of its signal input and transmit said multiplied signal 26 to the on-board electronic control circuit (10).

6. Mechatronic assembly (2) according to any of claims 1 to 5, **characterized in that** said on-board electronic control circuit (10) comprises an electronic modulation circuit (15) that generates a modulated unidirectional digital electrical signal (17) having encoded discrete states.

7. Mechatronic assembly (2) according to the preceding claim, **characterized in that** said electronic modulation circuit (15) encodes said modulated signal (17) as a function of the direction of the motor.

8. Mechatronic assembly (2) according to claim 6, **characterized in that** said electronic modulation circuit (15) encodes said modulated signal as a function of the speed of rotation of the motor.

9. Mechatronic assembly (2) according to claim 7, **characterized in that** said electronic modulation circuit (15) modulates the signal (17) in pulse width and encodes the duty cycle of each discrete state.

10. Mechatronic assembly (2) according to claim 7, **characterized in that** said electronic modulation circuit (15) modulates the amplitude of the signal (17) and encodes the amplitude of the high level of each discrete state with a fixed duty cycle.

11. Mechatronic assembly (2) according to claim 7, **characterized in that** said electronic modulation circuit (15) modulates the frequency of the signal (17) and encodes the frequency.

12. Mechatronic assembly (2) according to claim 6, **characterized in that** said electronic modulation circuit (15) encodes the amplitude of the high level of each discrete state as a function of a first information item, the duty cycle as a function of a second information item and the frequency as a function of a third information item.

13. Mechatronic assembly (2) according to claim 1, **characterized in that** said on-board electronic control circuit (10) comprises an impedance adapter (16) that applies a voltage to each of the space phasers according to the duty cycle

$$R_{MOSFET} = R_6 \times \frac{100}{R_{6H}-R_{6L}} + \left(100 - \frac{100}{R_{6H}-R_{6L}} \times R_{6H}\right)$$

where $R_6$ designates the duty cycle of the control signal from the external controller, $R_{6H}$ designates the upper limit of the duty cycle transmissible by the external controller, and $R_{6L}$ designates the lower limit of the duty cycle transmissible by the external controller.

14. Mechatronic assembly (2) according to claim 1, **characterized in that** said on-board electronic control circuit (10) comprises an impedance adapter (16) that applies a voltage to each of the space phasers according to the duty cycle $R_{MOSFET} = -\left(R_6 \times \frac{100}{50-R_{6L}}\right) + \left(100 + \frac{100}{50-R_{6L}} \times R_{6L}\right)$ when $R_6$ is less than 50% and

$R_{MOSFET} = R_6 \times \frac{100}{R_{6H}-50} + \left(100 - \frac{100}{R_{6H}-50} \times R_{6H}\right)$ when $R_6$ is greater than or equal to 50%;

or $R_6$ designates the duty cycle of the control signal from the external controller, $R_{6H}$ designates the upper limit of the duty cycle transmissible by the external controller, and $R_{6L}$ designates the lower limit of the duty cycle transmissible by the external controller.

15. Mechatronic assembly (2) according to either claim 13 or claim 14, **characterized in that** said ECU control unit (1) determines a duty cycle $R_6$ less than $R_{6L}$ OR greater than $R_{6H}$ to control a protection mode.

16. Mechatronic assembly (2) according to claim 1, **characterized in that** N varies as a function of the engine speed.

**Fig. 1**

**Fig.2**

## Fig. 3

## Fig. 4

## Fig. 5

## Fig. 6

**Fig. 7**

**Fig. 8**

## Fig. 9

Signal (17)

Direction CW
R=75%

Direction CCW
R=25%

Deceleration

Acceleration

Time (ms)

Signal (35)

R=50%

Deceleration

Acceleration

Time (ms)

Signals by (11)

Time (ms)

Signal (37)

Direction CW

Direction CCW

Time (ms)

## Fig. 10

Signal (17)

Direction CW
V(17)=+V/2

Direction CCW
V(17)=+V

Deceleration

Acceleration

Time
(ms)

Signal (35)

R=50%

Deceleration

Acceleration

Time
(ms)

Signals by (11)

Time
(ms)

Signal (37)

Direction CW

Direction CCW

Time
(ms)

## fig. 11

Proportional command

Symetrical command

## Fig. 12

Proportional command

Symetrical command

## Fig. 13

Proportional command

Symetrical command

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1461241
- WO 2016079315 A1
- WO 2014091152 A
- WO 9508214 A
- GB 2013011 A